# EUROPEAN PATENT APPLICATION

(11) **EP 1 098 223 A1**
(43) Date of publication of application: **09.05.2001**
(21) Application number: 00309726.8
(22) Date of filing: 03.11.2000
(51) Int. Cl.: G03F 7/027, G03F 7/16

(54) **Dry film photopolymerizable compositions**

(30) Priority: 03.11.1999 US 433153
(71) Applicant: Shipley Company LLC, Marlborough, MA 01752 (US)
(72) Inventor: Shelnut, James G., Northborough, Massachusetts 01532 (US)
(74) Representative: Buckley, Guy Julian

(57) **Abstract**

A dry film photoresist having a glass transition temperature (T_{g}) above room temperature. The dry film photoresist is tack free. An artwork may be placed directly on the photoresist without concern that the artwork may stick to the dry film photoresist or become contaminated with photoresist. The dry film photoresist may be laminated on a support sheet and wound into a roll without concern that the photoresist will stick to the backside of the support sheet. The dry film photoresist also has reduced cold flow problems.

## Description

The present application is a continuation-in-part application of U.S. Patent Application serial No.09/433,153, filed November 3, 1999.

### BACKGROUND OF THE INVENTION

The present invention is directed to a dry film photoresist. More specifically, the present invention is directed to a dry film photoresist that is tack free with reduced cold flow and an improved dry film construction.

In preparing a printed circuit board, a primary imaging photoresist is applied as a dry film to a circuit board laminate. The laminate is often a copper-clad epoxy board. A dry film photoresist consists of a cover or support sheet formed of a polyester, such as polyethyleneterephthalate (PET), a layer ofphotoimageable composition (photoresist) and a removable protective sheet. The support sheet is of a thickness that gives dry film shape, allowing the dry film to be rolled into a reel and subsequently be applied flat to the circuit board blank. The protective sheet is formed of a material, such as polyethylene, that is easily removed from the photoresist layer. The protective sheet is necessary as typical photoresist compositions are tacky and without the protective sheet the photoresist composition would stick to the backside of the PET when constructed into a wound up roll.

To apply the resist layer to the circuit board laminate, the protective sheet is removed, and the tacky photoresist layer is laminated using heat and pressure to the copper-clad laminate. An artwork or photomask with a desired pattern to be transformed onto the circuit board is then laid over the support sheet. The artwork has areas that are opaque to actinic radiation and other areas that are transparent to actinic radiation. The artwork or photomask remains on the photoresist layer and the photoresist layer is exposed to actinic radiation through the transparent portions of the artwork and through the support sheet. Exposure to actinic radiation causes a photoinduced chemical transformation of the photoresist and so doing to transfers the pattern of the artwork to the photoresist-coated circuit board laminate. Following exposure, the support sheet is removed and the photoresist layer is developed with an aqueous alkaline developer that washes away the unexposed portions of the photoresist layer. Subsequently, the blank is etched or plated in the portions from which the photoresist is removed, thereby forming the printed circuitry. As a final step, the remaining photoresist is stripped from the printed circuit board.

In the circuit board industry, there is a continual desire to obtain printed circuit boards with higher resolution, i.e., narrower resolved lines and spacing. For dry film photoresists an inherent limitation to resolution lies in the thickness of the support sheet. The support sheet limits resolution by a dimension approximating its thickness increasing the light path from the artwork, and inherently limiting resolution by light scattering, refraction, interfacial reflections, and the like. Various optical effects such as optical diffusion in, and reflections from, the support sheet, cause decreases in the desired resolution.

The resolution loss could be eliminated if the support sheet could be removed prior to exposure and the artwork or photomask laid directly on the photoresist layer. However, dry film photoresists are tacky by nature and tend to stick to the artwork. Sticking of the photoresist layer to the artwork makes registration difficult and after repeated applications the artwork becomes degraded with resist residue. Also, photoinitiators used in photoresists are subject to oxygen inhibition when the support sheet is removed; and photospeed of the photoresist deteriorates rapidly upon support sheet removal Accordingly, dry film photoresists are exposed through the support sheet by necessity. Elimination of the need for the support sheet during exposure would help to increase the resolution capabilities of the photoresist.

A number of dry film photoresists allegedly have been developed that reduce tackiness and omit the support sheet during exposure to actinic radiation. One approach to forming a dry film photoresist that permits removal of the support sheet, direct contact with the artwork, and exposure without the cover sheet is described, for example, in U.S. Pat. No. 4,530,896 to Christensen et al. Interposed between the support sheet and the photoresist layer is a thin intermediate layer of non-tacky material, such as polyvinyl alcohol, that allows artwork to be laid directly thereupon. The intermediate layer, that overlies the photoresist layer, even after support sheet removal, furthermore provides an oxygen barrier, protecting the photoinitiator in the photoresist from oxygen inhibition. While the intermediate layer eliminates the need for exposure through the relatively thick support sheet (0.7-1.1 mils), the intermediate layer adds some thickness (0.1-0.5 mils), increasing the light path from the artwork and inherently limiting resolution by light scattering, refraction, interfacial reflections, and the like. Also such an intermediate layer adds additional cost to dry film manufacturing. LAMINAR UF is an example of such a photoresist that incorporates an intermediate layer into dry film construction.

U.S. Pat. No. 5,391,458 to Conrad discloses a method of reducing the tackiness of dry film resist by baking the photoresist at mild temperatures. The support sheet of the photoresist is removed and the photoresist is baked at temperatures of from about 125° F to about 250° F. According to Conrad artwork may then be placed directly on the dry film without the photoresist sticking to the artwork. Although Conrad may eliminate some of the problems associated with a support sheet, and may eliminate the problems associated with the intermediate layer of Christensen et al., baking dry film, even at the temperatures of Conrad, can dry the photoresist such that it can not be processed. Dry film formulations vary, and the heat toleration of one dry film formulation may vary considerably from another. Thus, a worker in the art can not readily predict that a given dry film formulation may be processed after baking at Conrad's temperatures. The baking method described in Conrad is limited in its scope in dealing with the tackiness problem of dry film. Additionally, baking of dry film volatilizes necessary and important components of the photoresist composition such as low molecular weight monomers and sublimable photoinitiators and photosensitizers. Further, neither Christensen et al. nor Conrad address the issue of "cold flow" which is another problem to overcome in dry film photoresist.

As explained above, the dry film photoresist is sandwiched between a support sheet and a protective sheet. The manufacture of the dry film includes winding the multi-layered construction around a core to form a roll. The winding creates internal tensions and pressures such that the highly viscous, dry film photoresist relieves the pressures by oozing out along the sides of the dry film roll. Such a phenomenon is known as cold flow. Cold flow causes serious problems, such as thin spots, thin lines, or other areas where the dry film thickness is less than desired. Such internal non-uniformity can significantly compromise lithographic performance and reduce dry film production yields. Also, any surface protrusions in the support sheet and the protective sheet cause the dry film to cold flow causing thin spots and voids. Such protrusions are often present in the polyethylene protective sheet. Elimination of the need for a polyethylene protective sheet would help to eliminate this problem. In an attempt to reduce the spots and voids, dry film photoresists have thicknesses of about 1.3 mils to about 2 mils or more. However, such thickness restricts the fineness of features that may be created on circuit boards. The smaller the features created on a circuit board, the more components may be placed on the board, and the more compact the board may be.

Additionally, dry film cold flow can occur at the end of the dry film roll whereby internal pressures in the wound roll causes the photoresist to flow out and fuse with other areas of cold flow. Such end fusion requires slitting prior to use of the dry film. This results in significant waste of photoresist. When the dry film is unwound, the fused dry film flakes off or chips off. The flakes or chips can be caught between the dry film photoresist and the circuit board blank or other substrate employed resulting in processing variations and subsequent yield losses. Thus lithographic results are compromised. Such end fusion requires slitting prior to use of the dry film. This results in significant waste of photoresist.

Various methods have been developed in an attempt to control cold flow. Such methods include flash photolysis to harden the ends of the dry film roll and thereby produce a damming effect. Other methods include application of an adhesive end-capping device to stem the flow, use of embossed cover sheets to physically relieve the internal pressures, and use of amphoteric interpolymers in the photoimageable compositions to reduce the fluidity of the photoimageable compositions. For example, U.S. Pat. No. 4,943,513 to Lipson et al. discloses a dry film photoresist that allegedly substantially reduces cold flow. Lipson et al. address the problem of cold flow by incorporating metal ions having a charge of 2⁺ or higher in the polymer binder of the dry film photoresist. Such metals include titanium, copper, aluminum, zinc, zirconium and the like. The metal ions form a salt-bridge between the carboxyl groups of the polymer binder to cross-link the polymer binder and harden the dry film. Thus, the hardening of the dry film reduces cold flow. Thus, the anchoring of the dry film reduces cold flow.

Although there have been a number of methods and dry film photoresists directed to reducing tack or cold flow, the dry film industry has not yet developed a dry film that reduces the tack problem and cold flow problem simultaneously.

Another problem associated with dry film construction is disposal of the protective sheet. Protective sheets are composed of polymers such as polyethylene that are not biodegradable and are known to absorb monomers and other low molecular weight or sublimable specics from the photoresist. Accordingly, the protective cover sheets present a serious biohazard. Thus disposal of the protective sheet after use is restricted to limited dumping areas, and transportation of the protective sheet waste to the clumping areas is costly. Further, since the protective sheets are not reused but are disposed of after using only once, eliminating the need for such protective sheets would reduce the cost of employing dry film photoresists. Also, the elimination of the tack problem would also eliminate the need for the protective sheet.

Tack and cold flow problems have been difficult to solve in dry film photoresists because dry film photoresists have glass transition temperatures (T_{g}) of below room temperature (about 20° C). Glass transition temperature (T_{g}) is the temperature at which the dry film photoresist goes from a solid to a semisolid. Dry film photoresists are employed at temperatures above room temperature, and are stored at temperatures around room temperature. Thus, dry film photoresists are naturally tacky and are subject to cold flow. Accordingly, a dry film photoresist with a glass transition temperature above room temperature or higher is very desirable.

### SUMMARY OF THE INVENTION

The present invention is directed to dry film photoresists that are tack free, have reduced cold flow and a glass transition temperature (T_{g}) above room temperature. The present invention is further directed to dry film photoresist constructions that do not require a protective cover sheet. The present invention is also directed to dry film photoresist processes in which a carrier sheet is not required during exposure of the dry film to actinic radiation thereby improving resolution.

The dry film photoresists have sharp glass transition temperatures (T_{g}) such that the dry film photoresists are sufficiently viscous that they may be laminated on a substrate, and fill any imperfections in the substrate. The dry film photoresists contain high weight average molecular weight cross-linking agents. The high weight average molecular weight cross-linking agents compose greater than 50% by weight of the cross-linking agents employed in the dry film photoresists. In addition to the high weight average molecular weight cross-linking agents, the dry film photoresists are composed of polymer binders, photoinitiators, adhesion promoters and the like.

Advantageously, the dry film photoresists are tack free such that an artwork may be placed directly on the dry film during exposure without concern that the artwork may adhere to the dry film, or be contaminated by the dry film. Thus, the support sheet is not required during exposure, and does not interfere with exposure radiation. Accordingly, an enhanced resolution of the image patterned in the dry film results, and subsequently on a substrate or circuit board laminate. Also, since the dry film photoresists arc tack free, a costly protective cover sheet is not required. Thus, the cost of manufacture of the dry film is reduced, and the problem of discarding the environmentally hazardous cover sheet is eliminated. Further, since the protective cover sheet can be eliminated, the dry film photoresists do not require a thickness to compensate for imperfections in the protective cover sheet. Thus, the dry film photoresists may have a thickness of about 1.0 mil or less.

Further, the dry film photoresists are essentially free of the problems of cold flow. Thin spots, thin lines, voids and surface protrusions in the support sheet and protective sheet are significantly reduced such that lithographic performance is not compromised. Since the protective sheet may be eliminated in the dry film, such spols, lines and voids associated with the protective sheet are eliminated. End flow is reduced when the dry film is wound into a roll for storage. Thus, when the roll is unwound, flaking and chipping are minimal.

The dry film photoresists of the present invention may be employed as primary imaging resists such as for forming a printed circuit board. The dry film photoresists of the present invention may also be employed as a permanent photoimageable coating to function as a solder mask, permanent innerlayer, advanced dielectric, chip scale packaging, or the like in an electronic packaging substrate such as a printed circuit board.

A primary objective of the present invention is to provide a dry film photoresist that is tack free with reduced cold flow problems.

Another objective of the present invention is to provide a dry film photoresist that has a glass transition temperature above room temperature.

A further objective of the present invention is to provide a dry film photoresist that has a sharp glass transition temperature.

An additional objective of the present invention is to provide a dry film photoresist that is sufficiently dry such that artwork may be placed directly on the dry film during exposure to actinic radiation.
Still a further objective of the present invention is to provide a dry film photoresist that is dry enough to eliminate the need for a protective cover sheet.

Additional objectives and advantages of the present invention will be obvious to those of skill in the art after reading the following detailed description of the invention and the appended claims.

### DETAILED DESCRIPTION OF THE INVENTION

The present invention is directed to a dry film photoresist that is tack free and has reduced cold flow problems. The dry film photoresists of the present invention have a glass transition temperature (T_{g}) above room temperature (about 20° C) such that the dry films are tack free. Advantageously, the dry film photoresists are sufficiently tack free that artwork such as a photomask may be placed directly on the dry film photoresists without the artwork sticking to the dry film, and the artwork is not contaminated with the dry film. Accordingly, the support sheet may be removed from the dry film photoresist during exposure of the dry film to actinic radiation, The absence of the support sheet provides for improved resolution of the image on the dry film. Diffraction and other optical problems associated with the presence of the protective cover sheet are eliminated. Also, the protective cover sheet made of non-biodegradable material such as polyethylene can be eliminated from dry film construction.

The dry film photoresists contain high average weight molecular weight cross-linking agents in amounts of greater than 50% by weight of the cross-linking agents in the dry films. Such high average weight molecular weight cross-linking agents are monomers or oligomers with average molecular weights of at least about 500 daltons (D). Preferably, the average molecular weight of the monomers range from greater than 500 D to about 100,000 D, most preferably from about 15,000 D to about 75,000 D. Any suitable monomer or oligomer that may be employed as a cross-linking agent, and that has an average molecular weight within the aforementioned ranges may be employed to practice the present invention.

Preferred oligomers are acrylate oligomers Such oligomers include, but are not limited to, esters of acrylic acids, such as methyl acrylate, methyl methacrylate, hydroxy ethyl acrylate, butyl methacrylate, octyl acrylate, 2-ethoxy ethyl methacrylate, t-butylacrylate, 1,5-pentanediol diacrylate, N,N-diethylamino-ethyl acrylate, ethylene glycol diacrylate, 1,4-butanediol diacrylate, diethylene glycol diacrylate, hexamethylene glycol diacrylate, 1,3-propanediol diacrylate, decamthylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate , trimethylpropane triacrylate, pentaerythritol triacrylate, 2,2-di(p-hydroxy-phenol)-propane diacrylate, pentaerythritol tetracrylate, 2,2-di(p-hydroxyphenyl)-propane dimethacrylate, triethylene glycol diacrylate, polyoxyethyl-2-2-di(p-hydroxyphenyl )-propane dimethacrylate, triethylene glycol dimethacrylate, polyoxypropyltrimethylol propane triacrylate, ethylene glycol dimethacrylate, butylene glycol dimethacrylate, 1,3- propanediol dimethacrylate, butylene glycol dimethacrylate, 1,2,4-butanetriol trimethacrylate, 2,2,4-trimethyl-1,3 -pentanediol dimethacrylate, pentacrythritol triemthacrylate, 1-phenyl ethylene-1,2-dimethacrylate, pentaerythritol tetramethacrylate, trimethylol propane trimethacrylate, 1,5-pentanediol dimethacrylate, 1,4-benzenediol dimethacrylate and the like.

Other preferred cross-linking agents include acrylated urethane monomers. Such acrylated urethane monomers include, but are not limited to, urethane diacrylate, urethane triacrylate, urethane tetraacrylate, urethane di(metha)acrylate, urethane tri(metha)acrylate, urethane tetra(metha)acrylate, and the like.

The cross-linking agents of the dry films compose from about 5% by weight to about 40% by weight of the dry film, preferably from about 15% to about 30% by weight. The aforementioned oligomers and monomers may be combined in any suitable proportion as long as they compose greater than 50% by weight of the cross-linking agents of the dry film. Preferably, the dry film photoresists contain the high molecular weight cross-linking agents in amounts of from about 60% to about 95% by weight of the cross-linking agents, most preferably from about 80% to about 95% by weight. The large amounts of the high average weight molecular weight monomers and oligomers provide for a dry film having a T_{g} that exceeds room temperature (about 20° C). Also, the high content of the high average weight molecular weight monomers and oligomers provide for a dry film photoresist that has a sharp T_{g} as well. The sharp T_{g} indicates the melting point of the dry film photoresist. When the dry film reaches its T_{g} the dry film becomes sufficiently viscous enough that the dry film can be worked Such a sharp T_{g} enables the dry film photoresists to be laminated on a substrate, e.g., via a hot roll laminator under conditions to enable melting of the photoresist, such that the photoresist adheres to the substrate and exhibits sufficient fluid characteristics to fill imperfections in the substrate surface. T_{g} values of the dry films range from greater than about 20° C to about 130° C, preferably from about 45° C to about 110° C, most preferably, from about 60° C to about 90° C.

In addition to the high average weight molecular weight cross-linking agents, the remainder of the cross-linking component of the dry film may include lower average molecular weight monomers. Such lower average molecular weight monomers have an average molecular weight of below 500 D. Examples of suitable low average molecular weight monomers include, but are not limited to, acrylates, methacrylates, epoxy-acrylates such as the diacrylate (or methacrylate) esters of bisphenol A type resins and the like.

Other components of the dry film photoresists include film-forming polymer binder resins, photoinitiators, leveling agents, adhesion promoters, dyes, flexibilizing agents, antioxidants, and the like. The film-forming polymer binder resins may be added to the dry film photoresists to aid in coating and processing of the dry film. The polymer binder resins include polymer networks, of acrylics, styrenics, phenolics, epoxides, urethane polymers, polyesters, polymers of vinyl halides, vinylidene halides, vinyl esters and vinyl alcohols, polyamides, polyimides, silicones, polycarbonates, polyethers, polyolefins such as polyethylene and polypropylene, diolefin polymers such as polybutadiene, and polyisoprene, and poly(arylene sulfides) and poly(arylene Sulfones) The polymer chains are substantially composed of homopolymers and copolymers, but cross-linked with the aforementioned cross-linking agents. Preferred polymeric binder resins facilitate development of the dry film photoresist. Such polymeric binder resins contain sufficient acid groups to render non-exposed coating layer areas soluble in alkaline developer such as Carboset® 527 (obtainable from B.F. Goodrich) or Scripset 540® (obtainable from Monsanto). Examples of such preferred polymeric binder resins include, but are not limited to, α,β-ethylenically unsaturated acrylate or methacrylate resins, and the like. Polymer binder resins compose from about 50% by weight to about 90% by weight of the dry film photoresist, preferably fom about 60% by weight to about 80% by weight of the dry film. The polymer binder resins have average molecular weights of from about 250,000 D to about 1,000,000 D.

The remaining dry weight of the dry film is composed of adhesion promoters, photoinitiators, leveling agents, dyes, flexibilizing agents, antioxidants, and the like. The remaining components compose from about 0.5% by weight to about 10% by weight of the dry film. Adhesion promoters may include various triazoles such as benzatriazole, and substituted benzatriazoles, e.g., carboxy benzatriazole. Suitable dyes include solvent blue 57 and leuco crystal violet and the like. Suitable leveling agents include Modaflow® from Monsanto. Suitable antioxidants include triphenylphosphite and triphenylphosphine. Suitable photoiniators include, but are not limited to, Irgacure® 184 (obtainable from Ciba Geigy), xanthones, thioxanthones such as isopropyl thioxanthone, benzoin ethers, benzophenone, alkylamino benzophenones, and the like.

Flexibilizing agents include materials that are straight chain oligomers or polymers, preferably the flexibilizing agents contain hetero-atoms, such as oxygen or sulfur, to facilitate intermixing of the flexibilizing agent with other components of the dry film photoresist. For example, a preferred flexibilizing agent is Polymeg® 650 (obtainable from Quaker Chemical). Additional suitable flexibilizing agents include, but are not limited to, aliphatic urethanes such as those that are available from Sartomer. The flexibilizing agent may act as a reactive monomer. The use of the flexibilizing agent enables the dry film photoresists to exhibit sufficient flexibility to enable to wind the dry film into a roll. The flexibilizing agent also allows composition choices to be broadened and allows the use of materials that can enhance a photoresists overall profile, but may embrittle the photoresist.

The tack free dry film photoresists of the present invention may be prepared by any suitable method employed in the art. For example, the tack free dry film photoresist components may be mixed in a solvent carrier, and then coated onto a carrier or support sheet such as polyethyleneterephthalate (PET), or other suitable material. The solvent carrier is then removed such as by heating the coated support sheet at from about 80° C to about 120° C for about 3 to about 30 minutes. Because the dry film photoresists do not require protective cover sheets, the photoresists do not have to be thick enough to compensate for imperfections in the protective cover sheets. The dry film photoresists may have a thickness of about 1 0 mil or less, preferably, from about 0,1 mil to about 1 mil, more preferably from about 0.2 to about 0.8 mils, most preferably, from about 0.3 to about 0.5 mils. Accordingly, fineness of features created on a substrate such as a circuit board may be reduced.

The dried tack free dry film photoresist may then be wound into a tack free dry film roll without any protective cover sheet placed over the dry film opposite the support sheet. Because the dry film photoresist of the present invention is tack free, the dry film photoresist does not transfer to the backside of the support sheet. The dried dry film does not crack upon creasing or other manipulation that occurs in the roll formation.

The tack free dry film photoresists show considerable reduction in cold flow during storage. Thin spots, thin lines as well as internal non-uniformity of the dry film is reduced. Surface protrusions in the support sheet are reduced, and because a cover sheet may be excluded, spots and voids are significantly reduced. Also, end fusion is also reduced, thus when the roll is unwound flaking and chipping is no longer a serious problem.

When the dry film photoresist is employed for lithographic application, the roll is unwound and directly applied by lamination to a substrate surface. A protective cover sheet need not be employed in dry film photoresist construction, thus the problem of removal and disposal of the protective cover is eliminated. The protective cover is considered hazardous waste due to its ability to absorb reactive monomers from the photoresist. The dry film photoresist constructions of the present invention may be suitably applied onto a wide variety of substrates, and preferably onto a copper surface of a printed circuit board substrate. The dry film photoresists are preferably laminated onto the substrate followed by removal of the support sheet.

Dryness or tackiness may be assessed by any suitable method employed in the art. A preferred method is the "tissue paper test". The tissue paper test involves pressing a tissue paper into a dry film photoresist layer by hand manipulation, and then manually removing the tissue paper from the photoresist. The dryness or tackiness of the photoresist layer is measured by the ease of the removal of the tissue paper. A tacky dry film photoresist results in the tissue paper tearing upon removal from the photoresist. Also, imprints (naked eye inspection) from hand manipulation of the tissue paper are left in the photoresist layer. Dry film photoresists of the present invention do not result in the tissue paper tearing, and imprints (naked eye inspection) from manual pressing are not often left on the photoresist.

The dry film photoresists of the present invention may be applied to a substrate by any suitable method employed in the lithographic industry. Preferably, the dry film photoresists are applied to a substrate such as copper clad laminates (printed circuit board substrates) via a hot roll laminator. Suitable hot roll laminator conditions include from about 65° C to about 150° C, more preferably from about 90° C to about 140° C, most preferably from about 105° C to about 125° C. The hot roll laminator pressure may be from about 20 psi to about 50 psi, preferably from about 25 psi to about 35 psi. Laminator speed may be from about 1 to about 10 feet per minute (fpm), more preferably from about 2 fpm to about 8 fpm, most preferably from about 3 fpm to about 6 fpm The substrates may be pre-heated prior to entering the laminator.

Artwork or a photomask with a desired pattern may be placed directly on the dry film without concern that the artwork may stick to the dry film or become contaminated with the dry film. The dry film with the artwork may be exposed to actinic radiation without concern that a protective cover sheet may reflect or diffract the actinic radiation or incident light. Exposure radiation ranges from about 1 to about 250 mJ/cm². Exposure radiation activates the photoactive component of the photoresist to produce a patterned image on the dry film photoresist coating layer. Advantageously, the absence of the support sheet during exposure eliminates the problems of light scattering, refraction, internal reflections, and the like. Also, optical effects such as optical diffusion in the support sheet and reflections from the support sheet are eliminated. Thus, improved resolution is obtained,

Any suitable developer employed to develop dry film photoresists may be employed to develop the dry film of the present invention. An alkaline developer may be employed when the dry film contains a resin binder or other component with acid groups. A preferred alkaline developer is a sodium carbonate aqueous solution, particularly a 1% by weight or 2% by weight carbonate aqueous solution. Alternatively, an acidic developer solution may be employed when the dry film photoresist contains a binder resin or other component that has basic groups.

Developed dry film photoresist may be selectively processed on areas bared of dry film photoresist by known methods employed in the art. Examples of such methods include, but are not limited to, chemical etching or plating substrate areas bared of photoresist. After such processing, the dry film photoresist may be removed from the processed substrate employing any suitable stripping method known in the art.

In addition to being employed as primary imaging dry film photoresists for forming printed circuit boards, the dry film photoresists may be employed as permanent photoimageable coatings to function as solder masks, permanent innerlayers, advanced dielectrics, chip scale packaging and the like.

The following examples are intended to further illustrate the dry film photoresists of the present invention, and are not intended to limit the scope of the invention. Variations and modifications can be made without departing from the spirit and scope of the invention as set forth in the claims.

### Example 1

A dry, film photoresist was prepared by admixing the materials listed in the table below. Amounts are expressed as parts by weight based on the total weight of the photoresist.

| Component | Function | Amount |
|---|---|---|
| Urethane triacrylate | Monomer | 2.90% |
| Ethoxylated trimethylol triacrylate | Monomer | 2.90% |
| Pentaerythritol tetraacrylate | Monomer | 3.86% |
| Scriptset® 540 | Resin | 20.46% |
| Irgacure® 907 | Free Radical initiator | 1.62% |
| Isopropyl thioxanthone | Free Radical Initiator | 0.811% |
| Polymeg® 650 | Flexible Additive | 3.76% |
| Carboxy benzatriazole | Adhesion Promoter | 0.048% |
| Benzatriazole | Adhesion Promoter | 0.048% |
| Triphenylphosphite | Antioxidant | 0.154% |
| Triphenylphosphine | Antioxidant | 0.154% |
| Modaflow® | Leveling Agent | 0.251% |
| Solvent blue 67 | Coloring Agent | 0.058% |
| Leuco crystal violet | Coloring Agent | 0.251% |
| Propylene glycol methyl acetate | Solvent | 62.73% |

The above dry film photoresist was coated using a slot coater onto a support sheet made of polyethylene terephthalate to a thickness of 0.5 mils. The applied dry film photoresist coating was dried for 15 minutes at 90° C.

Dryness or tackiness of the dry film photoresist was assessed using the tissue paper test. A single sheet of tissue paper was pressed into the photoresist by hand manipulation, and then manually removed. The tissue paper did not tear upon removal, and no imprint (naked eye inspection) was left on the photoresist. Thus, the dry film photoresist passed the dryness test. The dry film was then wound into a roll without a protective sheet. The film was creased without cracking, and the dry film did not stick to the backside of the polyethylene terephthalate support sheet.

The dry film photoresist was laminated onto a mechanically scrubbed copper laminate which was heated to about 60° C with a hot roll laminator set at 110° C at a speed of 3 feet per minute to form a dry film composite. The support sheet was removed and the dry film composite was placed into a vacuum-frame exposure unit. Artwork was placed directly on the dry film. The artwork did not stick to the dry film, and no dry film adhered to the artwork. The dry film with the artwork was exposed to actinic radiation at 200 mJ.

After exposure, the artwork was removed, and the dry film photoresist was developed. Development was done in a 1% by weight sodium carbonate alkaline solution at 35° C with a 2X breakpoint that gave a Stouffer step 6-7 with a resolution of 1.0 mil lines and spaces. Thus, the dry films of the present invention are tack free, and provide improved resolution.

### Example 2

A 10 lb weight was placed on a stack of polyethylene terephthalate sheets each coated with a layer of the dry film photoresist disclosed in the above table in Example 1 for about 24 hours. The dry film was coated on the polyethylene terephthalate sheet as described above to form a dry film photoresist construction. After drying, the dry film constructions were stacked on each other such that the dry film photoresist of one construction was directly in contact with the backside of the polyethylene terephthalate sheet of another construction. After the 10 lb weight was removed, the dry film photoresist constructions were inspected with the naked eye. Dry film photoresist did not stick to the backside of any of the polyethylene terephthalate sheets, Also, no impressions were present in the dry film from the 10 lb weight.

A control of standard photoresist that falls outside the scope of the present invention, was prepared by the same method as described above in Example 1, and dry film constructions were also prepared. The constructions were stacked and a 10 lb weight was placed on the stack for about 24 hours. When the weight was removed, dry film photoresist stuck to the backside of the polyethylene terephthalate sheets, and a deep impression caused by the weight was left in the dry film. Thus, the dry film photoresists of the present invention are an improvement in the dry film photoresist art.

### Example 3

The dry film photoresist having the composition of Example 1 and support sheet was prepared. The dry film was laminated onto a mechanically scrubbed copper as described above. The polyethylene terephthalate support sheet was left on the dry film, and artwork was placed on the support sheet. The dry film was then exposed to actinic radiation at 250 mJ.

After exposure, the artwork was removed, and the photoresist was developed. Development was done with a 1% by weight sodium carbonate solution at 35° C with a 2X breakpoint to give a Stouffer step of 7-8 with a resolution of 4 mils lines and spaces.

The results showed that imaging without the support sheet in place improves the resolution. In Example 1 above, the resolution obtained without the support sheet provided 1 mil lines and spaces. When the support sheet was left on the dry film in present Example 2 during exposure, the resolution was less fine, i.e., 4 mils lines and spaces. Thus, the dry film photoresist of the present invention can provide for finer features, and is an improvement in the dry film photoresist art.

### Example 4

A dry film photoresist is prepared with the same components as in Example 1 above except that the low molecular weight monomer ethoxylated trimethylol triacrylate is not employed and Scripset® 540 resin is substituted with a polymer prepared from a combination of styrene/maleic anhydride that is esterified with hydroxyethyl-methacrylate. The combination polymer composes about 23.36% by weight of the dry film photoresist. Because the polymer cross-links into the photoresist during actinic radiation exposure, the low moleucular weight monomer is excluded. The dry film photoresist is prepared as the dry film in Example 1 above. The dry film photoresist is then laminated on a polyethyleneterephthalate support sheet as described above.

A tissue paper is manually pressed onto the dry film surface and then withdrawn. The tissue paper does not tear, and no imprint is left in the dry film.

## Claims

1. A dry film photoresist comprising a glass transition temperature of above room temperature.

2. The dry film photoresist of claim 1, wherein the glass transition temperature is from about 20° C to about 130° C.

3. The dry film photoresist of claim 2, wherein the glass transition temperature is from about 45° C to about 110°C.

4. The dry film photoresist of claim 3, wherein the glass transition temperature is from about 60° C to about 90° C.

5. The dry film photoresist of claim 1, further comprising a cross-linking agent having an average weight molecular weight of at least about 500 D.

6. The dry film photoresist of claim 5, wherein the average weight molecular weight of the cross-linking agent is from greater than about 500 D to about 100,000 D.

7. The dry film photoresist of claim 5, wherein the cross-linking agent has an average weight molecular weight of from about 15,000 D to about 75,000 D.

8. The dry film photoresist of claim 5, wherein the cross-linking agents having an average weight molecular weight greater than 500 D comprise greater than 50% by weight of cross-linking agents in the dry film photoresist.

9. The dry film photoresist of claim 8, wherein the cross-linking agents with an average weight molecular weight greater than 500 D range from about 60% by weight to about 95% by weight of the cross-linking agents.

10. The dry film photoresist of claim 9, wherein the cross-linking agents with an average weight molecular weight greater than 500 D range from about 80% by weight to about 95% by weight of the cross-linking agents.

11. The dry film photoresist of claim 5, wherein the cross-linking agent comprises acrylate oligomers, acrylated urethane monomers, or mixtures thereof.

12. The dry film photoresist of claim 11, wherein the acrylate oligomers comprise methyl acrylate, methyl methacrylate, hydroxy ethyl acrylate, butyl methacrylate, octyl acrylate, 2-ethoxy ethyl methacrylate, t-butylacrylate, 1,5-pentanediol diacrylate, N,N-diethylamino-ethyl acrylate, ethylene glycol diacrylate, 1,4-butanediol diacrylate, diethylene glycol diacrylate hexamethylene elycol diacrylate, 1,3-propanediol diacrylate, decamethylene glycol diacrylate, decamethylene glycol dimethacrylate, 1,4-cyclohexanediol diacrylate, 2,2-dimethylol propane diacrylate, glycerol diacrylate, tripropylene glycol diacrylate, glycerol triacrylate, trimethylpropane triacrylate, pentaerythritol triacrylate, 2,2-di(p-hydroxy-phenol)-propane diacrylate, pentaerythritol tetracrylate, 2,2-di(p-hydroxyphenyl)-propane dimethyacrylate, triethylene glycol diacrylate, polyoxyethyl-2-2-di(p-hydroxyphenyl)-propane dimetharylate, triethylene glycol dimethacrylate, polyoxypropyltrimethylol propane triacrylate, ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentacrythritol trimethacrylate, 1-phenyl ethylene-1,2-dimethacrylate, pentaerythritol tetramethacrylate, trimethylol propane trimethacrylate, 1,5-pentanediol dimethacrylate, 1,4-benzenediol dimethacrylate, or mixtures thereof.

13. The dry film photoresist of claim 11, wherein the acrylated urethane monomers comprise urethane diacrylate, urethane triacrylate, urethane tetraacrylate, urethane di(metha)acrylate, urethane tri(metha)acrylate, urethane tetra(metha)acrylate, or mixtures thereof.

14. The dry film photoresist of claim 5, further comprising a polymer binder resin, the polymer binder resin comprises acrylies, styrenies, phenolies, epoxides, urethane polymers, polyesters, polymers of vinyl halides, vinylidene halides, vinyl esters, vinyl alcohols, polyamides, polyimides, silicones, polycarbonates, polyethers, polyolefins, diolefins, poly(arylene sulfides), poly(arylene sulfones), or mixtures thereof.

15. The dry film photoresist of claim 14, further comprising photoinitiators, leveling agents, adhesion promoters, dyes, antioxidants, flexibilizing agents, or mixtures thereof.

16. A dry film photoresist construction comprising a dry film photoresist having a glass transition temperature of above room temperature, and a support sheet having a first side and a second side, the dry film photoresist is laminated on the first side of the support sheet.

17. The dry film photoresist construction of claim 16, wherein the glass transition temperature ranges from about 20° C to about 130° C.

18. The dry film photoresist construction of claim 17, wherein the glass transition temperature ranges from about 45° C to about 110° C.

19. The dry film photoresist construction of claim 18, wherein the glass transition temperature ranges from about 60° C to about 90° C.

20. The dry film photoresist construction of claim 19, further comprising a cross-linking agent having an average weight molecular weight oí at least about 500 D.

21. The dry film photoresist construction of claim 20, wherein the cross-linking agent having an average weight molecular weight of at least about 500 D comprises greater than 50% by weight of cross-linking agents in the dry film photoresist.

22. The dry film photoresist construction of claim 21, wherein the cross-linking agent having the average weight molecular weight of 500 D comprises 60% by weight to about 95% by weight of the cross-linking agents in the dry film photoresist.

23. The dry film photoresist construction of claim 20, wherein the cross-linking agent comprises acrylate oligomers, acrylated urethanes, or mixtures thereof.

24. The dry film photoresist construction of claim 16, wherein the dry film photoresist has a thickness of about 1.0 mil or less.

25. The dry film photoresist construction of claim 24, wherein the dry film photoresist has a thickness of from about 0,1 mil to about 1 mil.

26. The dry film photoresist construction of claim 25, wherein the dry film photoresist has a thickness of from about 0.2 mils to about 0.8 mils.

27. The dry film photoresist construction of claim 16, where the support sheet comprises polyethyleneterephthalate.

28. The dry film photoresist construction of claim 16, wherein the construction can be wound into a roll and the dry film photoresist laminated on the first side of the support sheet does not transfer to the second side of the support sheet.

29. The dry film photoresist construction of claim 16, wherein the dry film photoresist does not have a protective cover sheet opposite the support sheet.

30. The dry film photoresist construction of claim 16, wherein the dry film photoresist is tack free.

31. A method of forming a photoresist relief image on a substrate comprising:
a) applying a dry film photoresist construction to a surface of the substrate, the dry film photoresist construction comprises a dry film photoresist with a glass transition temperature of greater than room temperature laminated on a support sheet;
b) removing the support sheet from the dry film photoresist;
c) applying an artwork directly on the surface of the dry film photoresist;
d) exposing the dry film photoresist to actinic radiation; and
e) developing the exposed layer to provide a photoresist relief image.

32. The method of claim 31, wherein the glass transition temperature ranges from greater than about 20° C to about 130° C.

33. The method of claim 32, wherein the glass transition temperature ranges from about 45° C to about 110°C.

34. The method of claim 33, wherein the glass transition temperature ranges from about 60° C to about 90° C.

35. The method of claim 31, wherein the dry film photoresist comprises cross-linking agents having an average weight molecular weight at least about 500 D.

36. The method of claim 35, wherein the average weight molecular weight ranges from greater than 500 D to about 100,000 D.

37. The method of claim 36, wherein the average weight molecular weight ranges from about 15,000 D to about 75,000 D.

38. The method of claim 35, wherein the cross-linking agents with an average weight molecular weight of at least about 500 D comprise greater than 50% by weight of cross-linking agents in the dry film photoresist.

39. The method of claim 38, wherein the cross-linking agents with an average weight molecular weight of at least about 500 D comprise from about 60% by weight to about 95% by weight of the cross-linking agents.

40. The method of claim 39, wherein the cross-linking agents with an average weight molecular weight of at least about 500 D comprise from about 80% by weight to about 95% by weight of the cross-linking agents.

41. The method of claim 35, wherein the cross-linking agents comprise an acrylate oligomer, an acrylated urethane, or mixtures thereof.

42. The method of claim 31, wherein the dry film photoresist further comprises a polymer binder resin, photoinitiators, leveling agents, adhesion promoters dyes, flexibilizing agents, antioxidants, or mixtures thereof.

43. The method of claim 31, wherein the dry film photoresist is developed with an alkaline or acidic developer.

44. The method of claim 43, wherein the alkaline developer is a 1% or 2% by weight aqueous sodium carbonate solution.

45. The method of claim 31, wherein the dry film photoresist is tack free.

46. The method of claim 31, wherein the dry film photoresist does not have a protective cover sheet opposite the support sheet,

47. The method of claim 31, wherein the dry film photoresist has a thickness of from about 0.1 mil or less.

48. The method of claim 47, wherein the dry film photoresist has a thickness of from about 0.2 mils to about 0.8 mils.

49. The method of claim 48, wherein the dry film photoresist has a thickness of from about 0.3 to about 0.5 mils.
